# EUROPEAN PATENT APPLICATION

(11) **EP 2 087 942 A1**
(43) Date of publication of application: **12.08.2009**
(21) Application number: 07829867.6
(22) Date of filing: 16.10.2007
(51) Int. Cl.: B05D 3/10, C23C 18/18, H05K 3/18

(54) **PROCESS FOR PRODUCING METAL-FILM-COATED SUBSTRATE, METAL-FILM-COATED SUBSTRATE, PROCESS FOR PRODUCING METALLIC-PATTERN MATERIAL, AND METALLIC-PATTERN MATERIAL**

(30) Priority: 23.10.2006 JP 2006287881; 30.03.2007 JP 2007095713; 31.05.2007 JP 2007146197
(71) Applicant: FUJIFILM Corporation, Minato-ku Tokyo 106-8620 (JP)
(72) Inventor: NAGASAKI, Hideo, Ashigarakami-gun Kanagawa 258-8577 (JP); KANO, Takeyoshi, Ashigarakami-gun Kanagawa 258-8577 (JP)
(74) Representative: HOFFMANN EITLE
(86) International application number: PCT/JP2007/070133
(87) International publication number: WO 2008/050631

(57) **Abstract**

There are provided a metal film-carrying substrate including a substrate and a metal film with good adhesion to the substrate and being less dependent on temperature or humidity, and a method for preparation thereof. There are also provided a metal pattern material having a patterned metal portion with good adhesion to a substrate, being less dependent on temperature or humidity, and providing highly reliable insulation for a region where the patterned metal portion is not formed, and a method for preparation thereof. The method for preparing the metal film-carrying substrate includes: (a1) forming a polymer layer on a substrate, the polymer layer including a polymer that has a non-dissociating multidentate functional group capable of interacting with a plating catalyst or a precursor thereof and is directly and chemically bonded to the substrate; (a2) applying a multidentate plating catalyst or a precursor thereof to the polymer layer; and (a4) performing plating on the multidentate plating catalyst or precursor thereof; and (a3) optionally adding a metal to the polymer layer after the step (a2), the metal being different from the multidentate plating catalyst or precursor thereof.

## Description

### TECHNICAL FIELD

The present invention relates to metal film-carrying substrates and metal pattern materials and particularly to a method for preparing a metal film-carrying substrate or a metal pattern material useful as a metal circuit board or a printed circuit board.

### BACKGROUND ART

Metal circuit boards having patterned metallic circuits formed on an insulating substrate have been widely used in electronic components and semiconductor devices. In general, "subtractive process" is used to form such metal pattern materials. The subtractive process includes forming a photosensitive layer on a metal film formed on the surface of a substrate, wherein the photosensitive layer is sensitive to actinic ray irradiation, subjecting the photosensitive layer to imagewise exposure, then developing the layer to form a resist image, then etching the metal film to form a patterned metal, and finally separating the resist.

The patterned metal obtained by this method exhibits good adhesion between the metal film and the substrate, because of an anchor effect produced by irregularities formed on the substrate surface. Therefore, there is a problem in which the irregularities at the interface between the resulting patterned metal and the substrate can degrade the high frequency properties, when the patterned metal is used as a metal circuit. In addition, the process of forming irregularities on the substrate surface requires treatment of the substrate surface with a strong acid such as chromic acid, and, therefore, there is a problem in which a complicated process is necessary to form a patterned metal having good adhesion between the metal film and the substrate.

In order to solve the problem, there is proposed a surface treatment method including performing plasma treatment on the surface of a substrate, introducing a polymerization initiating group into the surface of the substrate, and polymerizing a monomer from the polymerization initiating group to form a polar group-containing surface graft polymer on the surface of the substrate, so that improved adhesion between the substrate and the metal film can be provided without roughening of the surface of the substrate (see, for example, Advanced Materials, No. 20, 2000, pp. 1481 to 1494). However, this method has a problem in which the polar group, particularly the dissociating group, of the graft polymer can easily cause water absorption or desorption upon changes in temperature or humidity so that the resulting metal film or the substrate can deform. When the patterned metal produced using this method is used as the circuit of a metal circuit board, the polar group- or dissociating group-containing graft polymer remaining at the substrate interface portion tends to retain water, ions or the like so that concern about temperature/humidity-dependency, ion migration resistance between wirings, or shape change may arise. Particularly when the patterned metal is used to form micro-wirings for printed circuit boards or the like, a high level of insulation is required between the wirings (patterned metal portions), and, therefore, under the current circumstances, there has been a demand for a further improvement in the reliability of insulation between wirings.

### DISCLOSURE OF INVENTION

### Objects to be Achieved by the Invention

The present invention has been made in view of the above conventional technical issues. An object of the invention is to provide a metal film-carrying substrate including a substrate and a metal film with good adhesion to the substrate and being less dependent on temperature or humidity, and to provide a method for production thereof. A second object of the invention is to provide a patterned metal material having a patterned metal portion with good adhesion to a substrate, being less dependent on temperature or humidity, and providing highly reliable insulation for a region where the patterned metal portion is not formed, and to provide a method for production thereof.

### Means for Solving the Problems

As a result of investigations in view of the above issues, the inventors have found that the objects can be achieved by the following means:
<1> A method for preparing a metal film-carrying substrate, including:
   (a1) forming a polymer layer on a substrate, the polymer layer including a polymer that has a non-dissociating multidentate functional group capable of interacting with a plating catalyst or a precursor thereof and is directly and chemically bonded to the substrate;
   (a2) applying a multidentate plating catalyst or a precursor thereof to the polymer layer; and
   (a4) performing plating on the multidentate plating catalyst or the precursor thereof; and
   (a3) optionally adding a metal to the polymer layer after the step (a2), the metal being different from the multidentate plating catalyst or the precursor thereof;
<2> The method for preparing a metal-carrying substrate of item <1>, wherein the non-dissociating multidentate functional group capable of interacting with the plating catalyst or the precursor thereof is a nitrogen-containing functional group, an oxygen-containing functional group, or a sulfur-containing functional group;
<3> The method for preparing a metal-carrying substrate of item <1> or <2>, wherein the non-dissociating multidentate functional group capable of interacting with the plating catalyst or the precursor thereof is a nitrogen-containing functional group;
<4> The method for preparing a metal-carrying substrate of any one of items <1> to <3>, wherein the multidentate plating catalyst or the precursor thereof is palladium or palladium ion;
<5> The method for preparing a metal-carrying substrate of any one of items <1> to <4>, wherein the metal being different from the multidentate plating catalyst or the precursor thereof is silver, copper, nickel, cobalt, tin, chromium, or zinc;
<6> A metal film-carrying substrate prepared by the method of any one of items <1> to <5>;
<7> A method for preparing a metal pattern material, including:
   (b1) forming a polymer layer on a substrate, the polymer layer including a polymer that has a non-dissociating multidentate functional group capable of interacting with a plating catalyst or a precursor thereof and is directly and chemically bonded to the substrate;
   (b2) applying a multidentate plating catalyst or a precursor thereof to the polymer layer;
   (b4) performing plating on the multidentate plating catalyst or the precursor thereof; and
   (b5) etching the resulting plating film in a pattern; and
   (b3) optionally adding a metal to the polymer layer after the step (b2), the metal being different from the multidentate plating catalyst or the precursor thereof;
<8> A method for preparing a metal pattern material, including:
   (c1) forming a polymer layer in a pattern on a substrate, the polymer layer including a polymer that has a non-dissociating multidentate functional group capable of interacting with a plating catalyst or a precursor thereof and is directly and chemically bonded to the substrate;
   (c2) applying a multidentate plating catalyst or a precursor thereof to the polymer layer; and
   (c4) performing plating on the multidentate plating catalyst or the precursor thereof; and
   (c3) optionally adding a metal to the polymer layer after the step (c2), the metal being different from the multidentate plating catalyst or the precursor thereof;
<9> The method for preparing a metal pattern material of item <7> or <8>, wherein the non-dissociating multidentate functional group capable of interacting with the plating catalyst or the precursor thereof is a nitrogen-containing functional group, an oxygen-containing functional group, or a sulfur-containing functional group;
<10> The method for preparing a metal pattern material of any one of items <7> to <9>, wherein the non-dissociating multidentate functional group capable of interacting with the plating catalyst or the precursor thereof is a nitrogen-containing functional group;
<11> The method for preparing a metal pattern material of any one of items <7> to <10>, wherein the multidentate plating catalyst or the precursor thereof is palladium or palladium ion;
<12> The method for preparing a metal pattern material of any one of items <7> to <11>, wherein the metal being different from the multidentate plating catalyst or the precursor thereof is silver, copper, nickel, cobalt, tin, chromium, or zinc;
<13> A metal pattern material prepared by the method of any one of items <7> to <12>.

### Effects of the Invention

According to the present invention, there are provided a metal film-carrying substrate including a substrate and a metal film with good adhesion to the substrate and being less dependent on temperature or humidity, and a method for preparation thereof. According to the invention, there are also provided a metal pattern material having a patterned metal portion with good adhesion to a substrate, being less dependent on temperature or humidity, and providing highly reliable insulation for a region where the patterned metal portion is not formed, and a method for preparation thereof.

### BEST MODE FOR CARRYING OUT THE INVENTION

The present invention is described in detail below. First, a description is given of the method of the invention for preparing a metal film-carrying substrate.

### <Method for Preparing Metal Film-Carrying Substrate>

The method of the invention for preparing a metal film-carrying substrate includes (a1) forming a polymer layer on a substrate, the polymer layer including a polymer that has a non-dissociating multidentate functional group capable of interacting with a plating catalyst or a precursor thereof and is directly and chemically bonded to the substrate, (a2) applying a multidentate plating catalyst or a precursor thereof to the polymer layer, (a3) optionally adding a metal to the polymer layer, the metal being different from the multidentate plating catalyst or the precursor thereof, and (a4) performing plating on the multidentate plating catalyst or the precursor thereof. Each step is described below.

### Step (a1)

In the step (a1), a polymer layer is formed on a substrate. The polymer layer includes a polymer that has a non-dissociating multidentate functional group capable of interacting with a plating catalyst or a precursor thereof (hereinafter also referred to as "interacting group") and is directly and chemically bonded to the substrate.

The step (a1) preferably includes (a1-1) preparing a substrate including a base material and a polymerization initiating layer that is formed on the base material and contains a polymerization initiator, and (a1-2) forming a polymer layer on the polymerization initiating layer, wherein the polymer layer includes a polymer having the interacting group and being directly and chemically bonded to the polymerization initiating layer. The step (a1-2) preferably includes bringing a polymer having a polymerizable group and the interacting group into contact with the polymerization initiating layer, and then applying energy so that the polymer can be directly and chemically bonded to the entire surface of the substrate (the entire surface of the polymerization initiating layer).

### Surface Grafting

The polymer layer may be formed on the substrate by a method generally called surface graft polymerization. Graft polymerization is a method for synthesizing a graft polymer, which includes providing an active species on a polymer compound chain and polymerizing an additional monomer, which is initiated with the active species. Particularly when the polymer compound to which the active species is added forms a solid surface, the method is called surface graft polymerization.

In an embodiment of the invention, any surface graft polymerization method publicly known through literatures may be used. For example, Shin-Kobunshi Jikkengaku 10 (New Polymer Experimentation 10), edited by the Polymer Society of Japan, 1994, published by Kyoritsu Publishing, p. 135 describes a photo-graft polymerization method and a plasma irradiation graft polymerization method for surface graft polymerization. Kyuchaku Gijutsu Binran (Adsorption Technology Handbook), edited by Takeuchi, published by NTS Inc. on February 1999, p. 203 and p. 695 also describes a method of irradiation graft polymerization with radiations such as γ-rays and electron beams. Specifically, the methods described in Japanese Patent Application Laid-Open (JP-A) Nos. 63-92658, 10-296895 and 11-119413 may be used for photo-graft polymerization.

Besides the surface grafting method, other methods including attaching a reactive functional group such as trialkoxysilyl, isocyanate, amino, hydroxyl, or carboxyl to the end of the polymer compound chain and bonding it to the functional group present on the surface of the substrate by a coupling reaction may also be used. Among these methods, the photo-graft polymerization method is preferably used to form the polymer layer so that a larger amount of the graft polymer can be produced.

### Substrate

In an embodiment of the invention, the "substrate" has a functional surface to which a polymer having a non-dissociating multidentate functional group capable of interacting with a plating catalyst or a precursor thereof can be directly and chemically bonded. The substrate itself may have such surface characteristics, or an additional intermediate layer (such as the polymerization initiating layer described later) formed on the base material may have such characteristics.

### Base Material or Substrate

The base material or substrate for use in an embodiment of the invention is preferably a dimensionally-stable sheet or plate. Examples include a sheet of paper or plastic (such as polyethylene, polypropylene, or polystyrene)-laminated paper, a metal plate (such as an aluminum, zinc, or copper plate), a plastic film (such as a cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, polyimide, epoxy resin, bismaleimide resin, polyphenylene oxide, liquid crystal polymer, or polytetrafluoroethylene film), and a paper or plastic film on which the metal described above is laminated or vapor-deposited. In an embodiment of the invention, epoxy resin or polyimide resin is preferably used for the base material. When the surface of the base material has the ability to form a direct chemical bond with a polymer having a non-dissociating multidentate functional group capable of interacting with a plating catalyst or a precursor thereof, the base material itself may also be used.

In an embodiment of the invention, the base material described in paragraphs [0028] to [0088] of JP-A No. 2005-281350 including a polyimide having a polymerization initiating moiety in the skeleton may also be used for the substrate.

The metal film-carrying substrate prepared by the method of the invention (the metal film-carrying substrate of the invention) may be patterned by etching to form a semiconductor package, various electrical circuit boards, and so on. For such applications, an insulating resin-containing substrate, specifically, a substrate made of an insulating resin or a substrate including a base material and an insulating resin layer formed thereon, as described below, is preferably used.

Any known insulating resin composition may be used to form an insulating resin substrate or an insulating resin layer. The insulating resin composition may contain a resin as a main component together with various additives depending on the purpose. For example, a polyfunctional acrylate monomer may be added to the composition for the purpose of increasing the strength of the insulating layer, or inorganic or organic particles may be added to the composition for the purpose of improving the electrical properties. As used herein, the term "insulating resin" means any resin having such a degree of insulating properties that it may be used for known insulating films or layers. In an embodiment of the invention, therefore, any resin that is not a completely insulating material but has a certain degree of insulating properties to meet the purpose may also be used.

For example, the insulating resin may be a thermosetting resin, a thermoplastic resin, or a mixture thereof, and examples of the thermosetting resin include epoxy resins, phenol resins, polyimide resins, polyester resins, bismaleimide resins, polyolefin resins, and isocyanate resins. Examples of epoxy resins include epoxy cresol novolac resins, bisphenol A epoxy resins, bisphenol F epoxy resins, epoxy phenol novolac resins, epoxy alkylphenol novolac resins, bisphenol F epoxy resins, naphthalene epoxy resins, dicyclopentadiene epoxy resins, epoxidized condensation products of phenols and phenolic hydroxyl group-containing aromatic aldehydes, triglycidyl isocyanurate, and alicyclic epoxy resins. One of these materials may be used alone, or two or more of these materials may be used in combination so that they can provide a high level of heat resistance and so on. Examples of polyolefin resins include polyethylene, polystyrene, polypropylene, polyisobutylene, polybutadiene, polyisoprene, cycloolefin resins, and copolymers of these resins.

Examples of the thermoplastic resin include phenoxy resins, polyethersulfone, polysulfone, polyphenylene sulfone, polyphenylene sulfide, polyphenyl ether, and polyether imide. Other examples of the thermoplastic resin include 1,2-bis(vinylphenylene)ethane resins (1,2-Bis(vinylphenyl)ethane) or modified resins thereof with polyphenylene ether resin (disclosed in in Amou, S. et al., Journal of Applied Polymer Science Vol. 92, 1252 to 1258 (2004)), liquid crystalline polymers (specifically, Vecster manufactured by Kuraray Co., Ltd.), and fluororesins (PTFE).

The thermoplastic and thermosetting resins may be used alone, or two or more of the thermoplastic and thermosetting resins may be used in combination. The thermoplastic and thermosetting resins may be used in combination to cover individual demerits and to produce good effects. For example, since the thermoplastic resin, such as polyphenylene ether (PPE), has low heat resistance, the thermoplastic resin may be alloyed with the thermosetting resin. For example, PPE may be alloyed with epoxy resin or triallyl isocyanate resin, or a PPE resin having an introduced polymerizable functional group may be alloyed with any other thermosetting resin. A cyanate ester resin has the most excellent dielectric properties among thermosetting resins, but it is rarely used alone and generally used as a modified resin with an epoxy resin, a maleimide resin, a thermoplastic resin, or the like. These are described in detail in Denshi Gijutu (Electronic Technology), 2002, No. 9, p. 35. In addition, a thermosetting resin including an epoxy resin and/or a phenol resin, and a thermoplastic resin including a phenoxy resin and/or polyether sulfone (PES) may also be used to improve the dielectric properties.

The insulating resin composition may also contain such a polymerizable double bond-containing compound as an acrylate or methacrylate compound, in particular, which is preferably polyfunctional. Other examples of the polymerizable double bond-containing compound that may be used include thermosetting or thermoplastic resins (such as epoxy resins, phenol resins, polyimide resins, polyolefin resins, or fluororesins) partially (meth)acrylated with methacrylic acid, acrylic acid, or the like.

In an embodiment of the invention, the insulating resin composition may be a composite (composite material) of a resin and other components to reinforce properties such as the mechanical strength, heat resistance, weather resistance, flame retardancy, water resistance, and electrical properties of the resin coating film. Examples of materials that may be used to form such a composite include paper, glass fibers, silica particles, phenol resins, polyimide resins, bismaleimide triazine resins, fluororesins, and polyphenylene oxide resins.

If necessary, the insulating resin composition may also contain one or more of fillers that have been used for general circuit board resin materials, such as inorganic fillers such as silica, alumina, clay, talc, aluminum hydroxide, and calcium carbonate, and organic fillers such as a cured epoxy resin, a crosslinked benzoguanamine reins, and a crosslinked acrylic polymer. If necessary, the insulating resin composition may also contain one or more of various additives such as colorants, flame retardants, tackifiers, silane coupling agents, antioxidants, and ultraviolet absorbing agents.

When these materials are added to the insulating resin composition, the content of any of these materials is preferably from 1 to 200% by mass, more preferably from 10 to 80% by mass, based on the amount of the resin. If the content is less than 1% by mass, the materials may be ineffective in reinforcing the properties. If the content is more than 200% by mass, the properties inherent to the resin, such as strength, may be degraded.

Specifically, the substrate for use in such applications is preferably made of an insulating resin having a dielectric constant (relative dielectric constant) of 3.5 or less at 1 GHz or composed of a base material and a layer that is formed of such an insulating resin on the base material. The substrate is also preferably made of an insulating resin having a dielectric loss tangent of 0.01 or less at 1 GHz or composed of a base material and a layer that is formed of such an insulating resin on the base material. The dielectric constant and dielectric loss tangent of the insulating resin may be measured by conventional methods. For example, the measurement may be performed using a cavity resonator perturbation method (for example, with an ultra-thin sheet εr and tanδ meter manufactured by Keycom Corporation) based on the method described in the Proceedings of 18th Japan Institute of Electronics Packaging Annual Meeting, 2004, p. 189. In an embodiment of the invention, it is also effective to select the insulating resin material from the stand point of dielectric constant or dielectric loss tangent as described above. Examples of the insulating resin with a dielectric constant of 3.5 or less and a dielectric loss tangent of 0.01 or less include liquid crystal polymers, polyimide resins, fluororesins, polyphenylene ether resins, cyanate ester resins, bis(bisphenylene)ethane resins, and modified resins thereof.

The substrate used in the method of the invention for preparing a metal film-carrying substrate preferably has a surface roughness of 500 nm or less, more preferably 100 nm or less, even more preferably 50 nm or less, most preferably 20 nm or less. The lower surface roughness of the substrate (or the lower surface roughness of the layer such as the intermediate layer or the polymerization initiating layer) is better, because the lower surface roughness can reduce the electrical loss during high-frequency transmission, when the resulting metal film-carrying substrate is used for wiring.

In an embodiment of the invention, a surface graft polymerization method including providing an active species on the surface of the substrate and initiating the production of a graft polymer from the active species may be used. In such a case, the substrate for use in the production of the graft polymer preferably includes a base material and a polymerization initiating layer that is formed on the base material and contains a polymerization initiator. The use of the substrate with such a structure allows efficient production of active sites so that a larger amount of the graft polymer can be produced. The polymerization initiating layer according to the invention is described below.

### Polymerization Initiating Layer

In an embodiment of the invention, the polymerization initiating layer may be a layer containing a polymer compound and a polymerization initiator or a layer containing a polymerizable compound and a polymerization initiator. In an embodiment of the invention, the polymerization initiating layer may be formed by a process that includes dissolving necessary components in a solubilizing solvent, applying the solution to the surface of the substrate by coating or any other method, and curing the film by heating or photoirradiation.

In an embodiment of the invention, any chemical compound that has good adhesion to the base material and can generates an active species upon application of energy such as actinic ray irradiation may be used for the polymerization initiating layer. Specifically, a mixture of a polymerization initiator and a polyfunctional monomer or a hydrophobic polymer having a polymerizable group in its molecule may be used.

Examples of such a hydrophobic polymer having a polymerizable group in its molecule include diene homopolymers such as polybutadiene, polyisoprene, and polypentadiene; homopolymers of allyl group-containing monomers such as allyl (meth)acrylate and 2-allyloxyethyl methacrylate; binary or multi-component copolymers having a repeating unit derived from styrene, (meth)acrylate ester, (meth)acrylonitrile, or the like and another repeating unit derived from a diene monomer such as butadiene, isoprene or pentadiene, or an allyl group-containing monomer; and carbon-carbon double bond-containing linear polymers or terpolymers such as unsaturated polyester, unsaturated polyepoxide, unsaturated polyamide, unsaturated polyacrylic, and high-density polyethylene. In the description, the term "(meth)acryl" is also used to refer to one or both of "acryl" and "methacryl." The content of any of these polymerizable compounds in the solids of the polymerizable layer is preferably from 10 to 100% by mass, more preferably from 10 to 80% by mass.

The polymerization initiating layer contains a polymerization initiator to induce polymerization initiating ability upon application of energy. The polymerization initiator to be used in this process may be appropriately selected from known thermal polymerization or photopolymerization initiators capable of inducing polymerization initiating ability upon application of actinic rays, heat, electron beams, or the like, depending on the purpose. In particular, photopolymerization is preferably utilized in view of suitability for production, and, therefore, photopolymerization initiators are preferably used. Any type of photopolymerization initiator may be used, as long as it is sensitive to actinic rays applied and can initiate surface graft polymerization from the polymerization initiating layer containing it. For example, radical polymerization initiators, anionic polymerization initiators, cationic polymerization initiators, or the like may be used. In view of reactivity, radical polymerization initiators are preferably used.

Examples of such photopolymerization initiators include acetophenones such as p-tert-butyltrichloroacetophenone, 2,2'-diethoxyacetophenone, and 2-hydroxy-2-methyl-1-phenylpropane-1-one; ketones such as benzophenone, 4,4'-bisdimethylaminobenzophenone, 2-chlorothioxanthone, 2-methylthioxanthone, 2-ethylthioxanthone, and 2-isopropylthioxanthone; benzoin, benzoin ethers such as benzoin methyl ether, benzoin isopropyl ether, and benzoin isobutyl ether; and benzyl ketals such as benzyl dimethyl ketal and hydroxycyclohexyl phenyl ketone. The content of the polymerization initiator in the solids of the polymerization initiating layer is preferably from 0.1 to 70% by mass, particularly preferably from 1 to 40% by mass.

The solvent used in the process of applying the polymerizable compound and the polymerization initiator may be of any type, as long as it can dissolve these components. In view of easiness of drying or workability, the solvent preferably has a boiling point that is not excessively high and, specifically, should be selected from those having a boiling point of about 40°C to about 150°C. Examples include acetone, methyl ethyl ketone, cyclohexane, ethyl acetate, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, methanol, ethanol, 1-methoxy-2-propanol, 3-methoxypropanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, and 3-methoxypropyl acetate. These solvents may be used alone or in any combination. The solids content of the coating solution is preferably from 2 to 50% by mass.

In the process of forming the polymerization initiating layer on the base material, the coating composition is preferably applied in an amount of 0.1 to 20 g/m², more preferably 0.5 to 15 g/m², as dry mass, in order to induce sufficient polymerization initiating ability and to prevent film delamination with the film properties maintained.

As mentioned above, in an embodiment of the invention, the polymerization initiating layer may be formed by a process that includes placing a polymerization initiating layer-forming composition on the base material by coating or the like and removing the solvent to form a film. In this process, the film is preferably cured by heating and/or photoirradiation. In particular, the film may be dried by heating and then pre-cured by photoirradiation. This process is particularly preferred, because the polymerizable compound is preliminarily cured to a certain extent in this process so that the polymerization initiating layer can be effectively prevented from being delaminated as a whole after the graft polymer is produced on the polymerization initiating layer. The heating temperature and the heating time may be selected from the conditions that allow satisfactory evaporation of the solvent from the coating. In view of suitability for production, the temperature and the drying time are preferably 100°C or lower and 30 minutes or less, respectively, and heating conditions of a drying temperature of 40 to 80°C and a drying time of 10 minutes or less are preferably selected.

In the photoirradiation process optionally performed after drying by heating, a light source for use in the reaction to produce the graft polymer described later may also be used. In the following graft polymer-producing process, inhibition of active sites produced on the polymerization initiating layer by application of energy and inhibition of the production of the graft polymer should be prevented. From this point of view, the photoirradiation is preferably performed to such an extent that the polymerization initiator present in the polymerization initiating layer is not completely consumed even through it is radically polymerized in the process of curing the polymerizable compound. In general, the photoirradiation time is preferably 30 minutes or less, while it depends on the power of the light source. As a guide for the pre-curing, the film remaining rate should be 80% or less after washing with a solvent, and the initiator remaining rate should be 1% or more after the pre-curing.

A polymerization initiating layer including the polymer described in JP-A No. 2004-161995 that has a polymerization initiating pendant group attached to the side chain is also preferably used as an alternative to the polymerization initiating layer containing the polymerizable compound and the polymerization initiator. Specifically, the side chain of this polymer has a functional group capable of initiating polymerization (polymerization initiating polymer) and a crosslinkable group (hereinafter, the polymer referred to as "polymerization initiating polymer"). This polymer has a polymerization initiating group attached to the polymer chain and is capable of forming a polymerization initiating layer in which the polymer chain is immobilized by a crosslinking reaction. In an embodiment of the invention, the polymerization initiating layer formed as described above is also preferred.

Examples of the polymerization initiating polymer used in this process include the polymers disclosed in paragraphs [0011] to [0158] of JP-A No. 2004-161995. Some examples of particularly preferred polymerization initiating polymers are shown below.

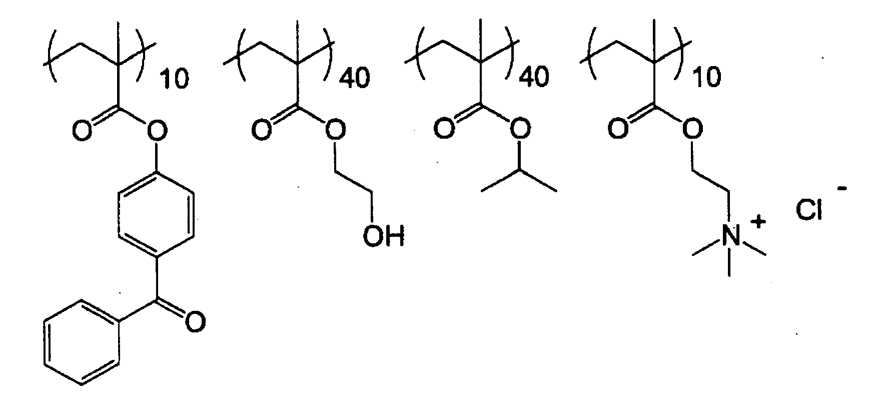

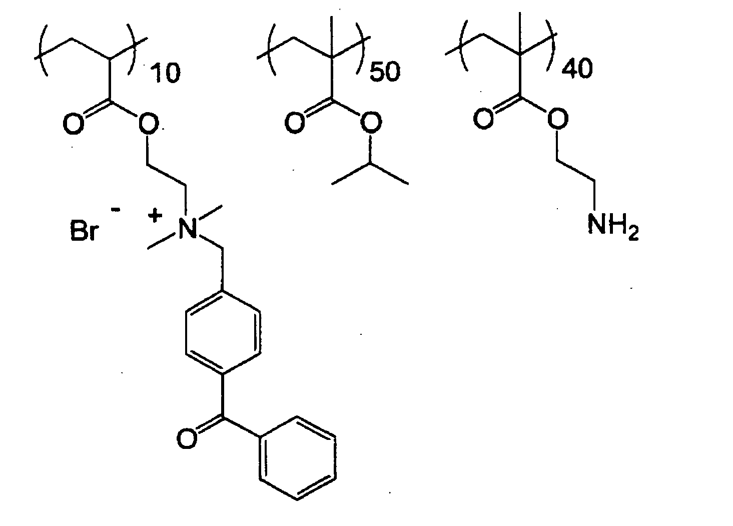

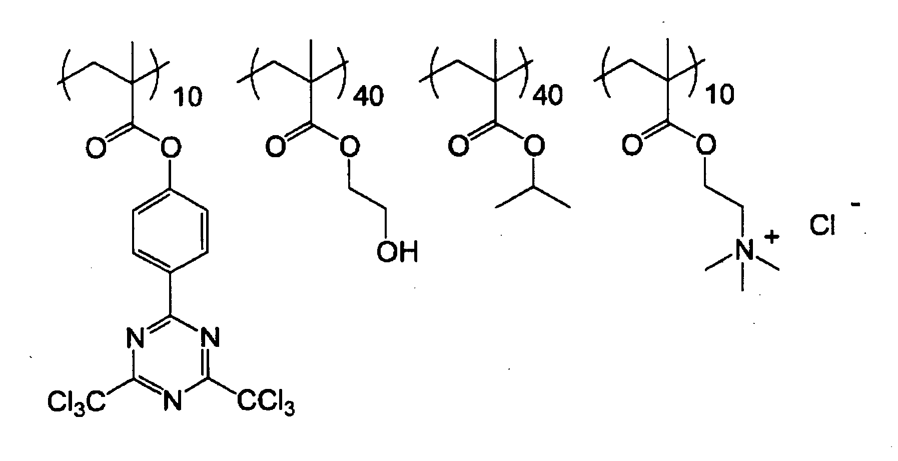

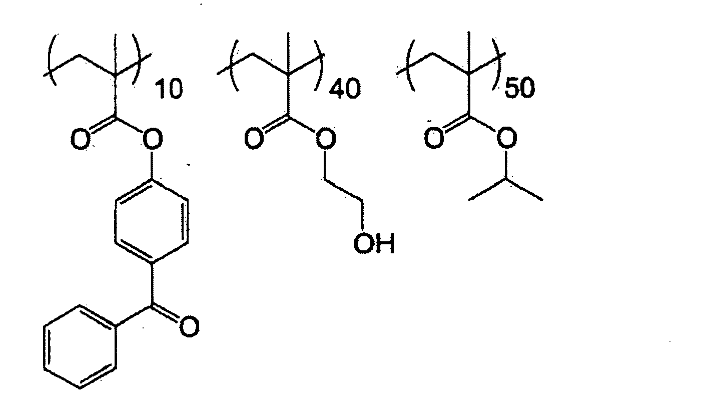

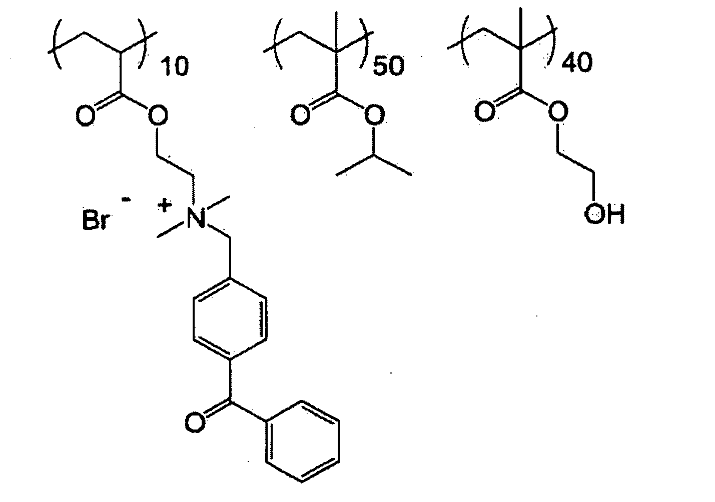

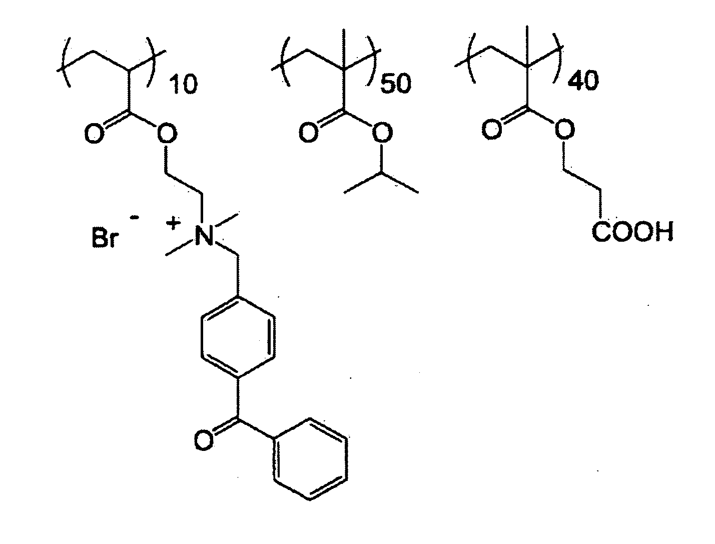

### Production of Polymerization Initiating Layer

In an embodiment of the invention, the polymerization initiating layer including the polymerization initiating polymer may be formed by a process that includes dissolving the polymerization initiating polymer in an appropriate solvent to form a coating liquid, placing the coating liquid on the base material by coating or any other method, removing the solvent, and allowing a crosslinking reaction to proceed. Therefore, the polymerization initiating polymer is immobilized when the crosslinking reaction is allowed to proceed. The immobilization by the crosslinking reaction may be performed by a method based on a self-condensation reaction of the polymerization initiating polymer or by a method using a crosslinking agent in combination with the polymer. The method using a crosslinking agent is preferred. When the crosslinkable group is -NCO, for example, the method based on a self-condensation reaction of the polymerization initiating polymer may benefit from the property of promoting the self-condensation reaction upon application of heat. When the self-condensation reaction is allowed to proceed, a crosslinked structure can be formed.

In the method using a crosslinking agent in combination with the polymer, known conventional crosslinking agents such as those listed in "Crosslinking Agent Handbook," edited by Shinji Yamashita may be used. Preferred examples of a combination of the crosslinkable group in the polymerization initiating polymer and the crosslinking agent (the crosslinkable group, the crosslinking agent) include (-COOH, polyamine), (-COOH, polyaziridine), (-COOH, polyisocyanate), (-COOH, polyepoxy), (-NH₂, polyisocyanate), (-NH₂, aldehydes), (-NCO, polyamine), (-NCO, polyisocyanate), (-NCO, polyalcohol), (-NCO, polyepoxy), (-OH, polyalcohol), (-OH, polyhalogenated compound), (-OH, polyamine), and (-OH, acid anhydride). In particular, (-OH, polyisocyanate) is a more preferred combination of the functional group and the crosslinking agent, because such a combination can form a urethane bond through the crosslinking reaction and therefore a strong crosslink.

In an embodiment of the invention, the crosslinking agent may have any of the structures shown below.

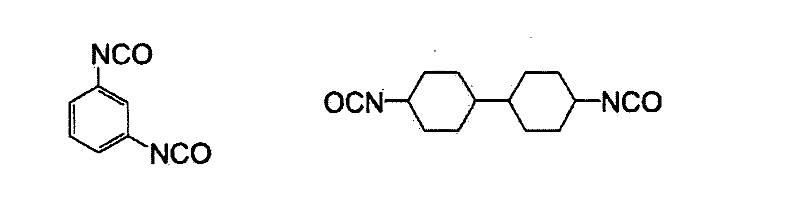

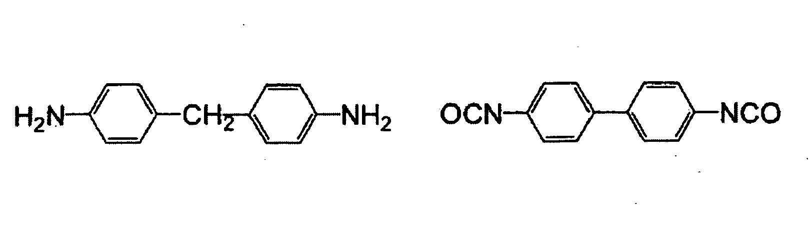

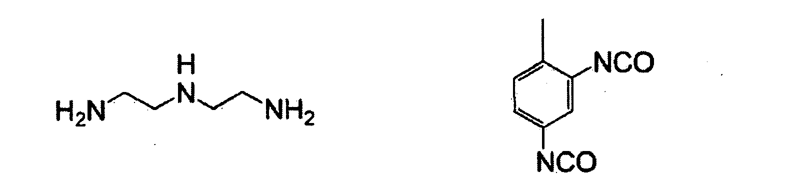

Such a crosslinking agent may be added to the polymerization initiating polymer-containing coating liquid in the process of forming the polymerization initiating layer. Thereafter, the coating film may be dried by heating, which allows the crosslinking reaction to proceed, so that a strong crosslinked structure can be formed. More specifically, the crosslinking reaction is allowed to proceed through a dehydration reaction expressed by formula ex1. below or an addition reaction expressed by formula ex2. below, when the crosslinked structure is formed. Temperature conditions for these reactions are preferably from 50°C to 300°C, more preferably from 80°C to 200°C.

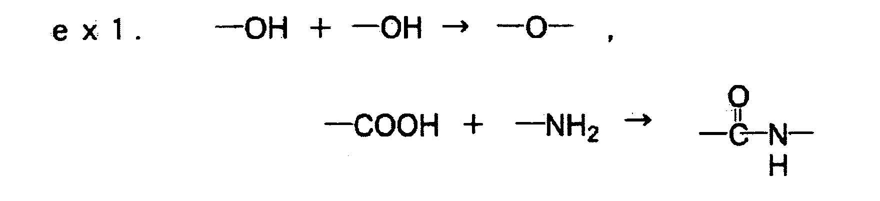

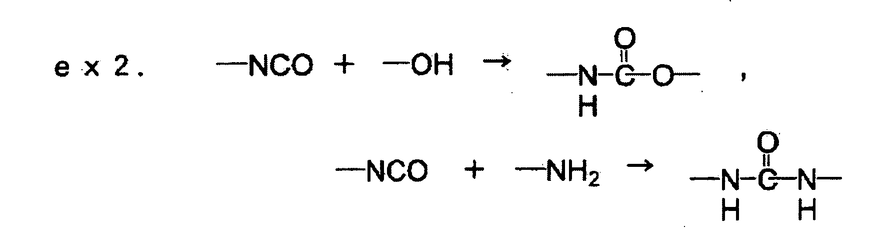

In general, the content of the crosslinking agent in the coating liquid is preferably from 0.01 to 50 equivalents, more preferably from 0.01 to 10 equivalents, even more preferably from 0.5 to 3 equivalents, based on the number of moles of the crosslinkable group, from the view point of the influence of the unreacted crosslinking component residue on the polymerization reaction, while it depends on the amount of the crosslinkable group introduced in the polymerization initiating polymer.

The solvent used in the process of forming the polymerization initiating layer may be of any type, as long as it can dissolve the polymerization initiating polymer. In view of easiness of drying or workability, the solvent preferably has a not so high boiling point and, specifically, should be selected from those having a boiling point of about 40°C to about 150°C. Examples include acetone, methyl ethyl ketone, cyclohexane, ethyl acetate, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, methanol, ethanol, 1-methoxy-2-propanol, 3-methoxypropanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, and 3-methoxypropyl acetate. These solvents may be used alone or in any combination. The solids content of the coating solution is preferably from 2 to 50% by weight.

In the process of forming the polymerization initiating layer including the polymerization initiating polymer, the coating composition is preferably applied in an amount of 0.1 to 20 g/m², more preferably 1 to 15 g/m², as dry weight, in view of the ability to initiate surface graft polymerization or the film properties.

In an embodiment of the invention, when the substrate used includes the base material and the insulating resin layer formed thereon as described above, the insulating resin layer preferably contains a known polymerization initiator so as to serve as an insulating polymerization-initiating layer. The polymerization initiator added to form the insulating polymerization-initiating layer may be of any type, such as a thermal polymerization initiator or a photopolymerization initiator (a radical polymerization initiator, an anionic polymerization initiator, or a cationic polymerization initiator) as described above, a polymer compound having an active carbonyl group in the side chain as disclosed in JP-A Nos. 09-77891 and 10-45927, or a polymer having a crosslinkable group and a polymerization-initiating functional group in the side chain (polymerization initiating polymer). In general, the content of the polymerization initiator in the insulating polymerization-initiating layer is preferably from about 0.1 to about 50% by mass, more preferably from about 1.0 to 30.0% by mass, based on the solids of the insulating layer.

### Production of Graft Polymer

In a mode of the step (a1), the graft polymer may be produced using a method based on a coupling reaction between the functional group present on the substrate surface and the reactive functional group attached to the end or the side chain of the polymer compound, or using a photo-graft polymerization method. In a preferred embodiment of the invention, the substrate used includes a base material and a polymerization initiating layer formed thereon, and a polymer layer is formed on the polymerization initiating layer, wherein the polymer layer includes a polymer that has a non-dissociating multidentate functional group capable of interacting with a plating catalyst or a precursor thereof (an interacting group) and is directly and chemically bonded to the polymerization initiating layer (step (a1-2)). In a more preferred embodiment, a polymer having a polymerizable group and an interacting group is brought into contact with the polymerization initiating layer, and then energy is applied thereto so that the polymer can be directly and chemically bonded to the entire surface of the substrate (the entire surface of the polymerization initiating layer). In this process, the compound having the polymerizable group and the interacting group or a composition containing the compound is brought into contact with the surface of the polymerization initiating layer so that the compound can be directly bonded to the surface of the polymerization initiating layer through an active species produced thereon.

The contact may be achieved by immersing the polymerization initiating layer-carrying substrate in a liquid composition containing the compound having the polymerizable group and the interacting group. In view of handling property or production efficiency, a layer mainly composed of a composition that contains the compound having the polymerizable group and the interacting group may be formed on the substrate surface (the surface of the polymerization initiating layer) by a coating method as described later.

A description is given below of the compound having the polymerizable group and the non-dissociating multidentate functional group capable of interacting with the plating catalyst or the precursor thereof (the interacting group), which is used for the production of a graft polymer by surface graft polymerization method in an embodiment of the invention. In an embodiment of the invention, the interacting group of the compound having the polymerizable group and the interacting group (the non-dissociating multidentate functional group capable of interacting with the plating catalyst or the precursor thereof) is a functional group that does not dissociate to produce protons and can interact and coordinate with the plating catalyst or the precursor thereof through an intermolecular force. The interacting group is preferably a nitrogen-containing functional group, an oxygen-containing functional group, a sulfur-containing functional group, or the like. Examples of the interacting group include nitrogen-containing functional groups such as imido, pyridyl, tertiary amino, ammonium, pyrrolidone, amidino, a btriazine ring structure-containing group, an isocyanuric structure-containing group, nitro, nitroso, azo, diazo, azido, cyano, and cyanate (R-O-CN); oxygen-containing functional groups such as ether, carbonyl, ester, an N-oxide structure-containing group, an S-oxide structure-containing group, and an N-hydroxy structure-containing group; sulfur-containing functional groups such as thioether, thioxy, sulfoxide, sulfone, sulfide, a sulfoxyimine structure-containing group; a sulfoxonium salt structure-containing group, a sulfonate ester structure-containing group; phosphorus-containing functional groups such as a phosphine group; a group containing a halogen atom such as chlorine or bromine; and an unsaturated ethylene group. If the relationship between adjacent atoms or atomic groups allows non-dissociating properties, an imidazole, urea, or thiourea group may also be used. In particular, an ether group (more specifically a structure represented by -O-(CH₂)ₙ-O-, wherein n is an integer of 1 to 5), a pyridyl group, a cyano group, an ether group, or a thioether group is preferred, because the structure including such a group can have high polarity and offer high adsorption performance to the plating catalyst or the like. This functional group has the function of interacting with the plating catalyst or the precursor thereof but does not have a dissociating polar group (hydrophilic group). Therefore, the polymer layer made of a graft polymer having this functional group will be less dependent on temperature or humidity.

In an embodiment of the invention, the compound having the polymerizable group and the interacting group may be in the form of any of a monomer, a macromonomer, and a polymer. In view of formability or controllability of the polymer layer, a polymer (a polymer having the polymerizable group and the interacting group) is preferably used. The polymer having the polymerizable group and the interacting group is preferably produced by introducing an ethylenic addition-polymerizable unsaturated group (polymerizable group) such as a vinyl, allyl, or (meth)acrylic group, as the polymerizable group, into a homopolymer or copolymer produced with an interacting group-containing monomer. The polymer having the polymerizable group and the interacting group preferably may have the polymerizable group at least at the end of the main chain or in the side chain, preferably in the side chain. In an embodiment of the invention, the polymerizable group is a functional group that allows coupling between the compounds each having the polymerizable group and the interacting group or between the substrate and the compound having the polymerizable group and the interacting group upon application of energy. Besides the ethylenic addition-polymerizable unsaturated group, the polymerizable group may be vinyl, vinyloxy, allyl, acryloyl, methacryloyl, oxetane, epoxy, isocyanate, an active hydrogen-containing functional group, an active group of an azo compound, or the like.

Monomers used to produce the polymer having the polymerizable group and the interacting group may be vinylpyridines, N-vinylpyrrolidones, or the like. One or more of these monomers may be used alone or in combination.

The content of the unit derived from the interacting group-containing monomer in the polymer having the polymerizable group and the interacting group is preferably from 50 to 95% by mole, more preferably from 40 to 80% by mole, in view of interaction with the plating catalyst or the precursor thereof.

Besides the interacting group-containing monomer, an additional monomer may be used in the process of synthesizing the polymer having the polymerizable group and the interacting group. Such an additional monomer may be a general polymerizable monomer such as a diene monomer or an acrylic monomer.

The polymer having the polymerizable group and the interacting group may be synthesized as described below. Examples of the synthesis method include (i) a method of copolymerizing an interacting group-containing monomer and a polymerizable group-containing monomer, (ii) a method that includes copolymerizing an interacting group-containing monomer and a double bond precursor-containing monomer and then introducing a double bond by treatment with a base or the like, and (iii) a method of performing a reaction between an interacting group-containing polymer and a polymerizable group-containing monomer to introduce a double bond (to introduce a polymerizable group). In view of suitability for synthesis, preferred are the method (ii) that includes copolymerizing an interacting group-containing monomer and a double bond precursor-containing monomer and then introducing a double bond by treatment with a base or the like, and the method (iii) of performing a reaction between an interacting group-containing polymer and a polymerizable group-containing monomer to introduce a double bond.

The interacting group-containing monomer for use in the synthesis of the polymer having the polymerizable group and the interacting group may be the same as described above. One or more monomers may be used alone or in combination.

The polymerizable group-containing monomer to be copolymerized with the interacting group-containing monomer may be ally (meth)acrylate, 2-allyloxyethyl methacrylate, or the like. The double bond precursor-containing monomer may be 2-(3-chloro-1-oxopropoxy)ethyl methacrylate, 2-(3-bromo-1-oxopropoxy)ethyl methacrylate, or the like.

In addition, a polymerizable group-containing monomer may be used to introduce an unsaturated group based on the reaction with a functional group in the interacting group-containing polymer, such as a carboxyl or amino group or a salt thereof, a hydroxyl group, or an epoxy group. Such a polymerizable group-containing monomer may be (meth)acrylic acid, glycidyl (meth)acrylate, allyl glycidyl ether, 2-isocyanatoethyl (meth)acrylate, or the like.

In an embodiment of the invention, the polymer having the polymerizable group and the interacting group preferably has an average molecular weight of 1,000 to 700,000, more preferably 2,000 to 300,000. In an embodiment of the invention, the polymer having the polymerizable group and the interacting group preferably has a degree of polymerization of 10 or more, more preferably 20 or more, and preferably has a degree of polymerization of 7,000 or less, more preferably 3,000 or less, even more preferably 2,000 or less, particularly preferably 1,000 or less.

Examples of the polymer having the polymerizable group and the interacting group suitable for use in an embodiment of the invention are shown below, but not limited them.

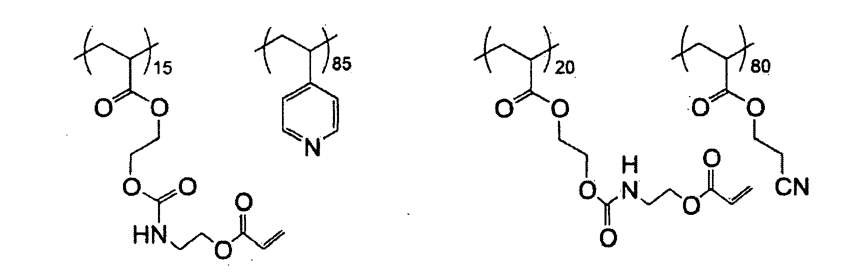

In an embodiment of the invention, the compound having the polymerizable group and the interacting group may also have a polar group, as long as the advantageous effects of the invention are not reduced due to the water absorption rate of the polymer layer formed. For example, when a protective layer is provided after the metal film is formed by the process described later, the polar group can increase the adhesive strength at the contact region between the polymer layer and the protective layer.

The solvent used to form a composition containing the compound having the polymerizable group and the interacting group (such as the polymer having the polymerizable group and the interacting group) may be of any type, as long as it can dissolve the main components of the composition including the compound having the polymerizable group and the interacting group. A surfactant may also be added to the solvent. Examples of the solvent that may be used include alcohol solvents such as methanol, ethanol, isopropanol, ethylene glycol, glycerin, and propylene glycol monomethyl ether; acids such as acetic acid; ketone solvents such as acetone and cyclohexanone; and amide solvents such as formamide and dimethylacetamide.

In an embodiment of the invention, when a composition containing the compound having the polymerizable group and the interacting group is applied to the substrate or the polymerization initiating layer, the solvent may be selected so that the substrate or the polymerization initiating layer can have a solvent absorption rate of 5 to 25%. The solvent absorption rate may be determined by a process that includes immersing the substrate or the base material provided with the polymerization initiating layer in the solvent and lifting out it after 1000 minutes to measure the change in mass. When a composition containing the compound having the polymerizable group and the interacting group is applied to the substrate or the polymerization initiating layer, the solvent may be selected so that the substrate or the polymerization initiating layer can have a degree of swelling of 10 to 45%. The degree of swelling may be determined by a process that includes immersing the substrate or the base material provided with the polymerization initiating layer in the solvent and lifting out it after 1000 minutes to measure the change in thickness.

The surfactant optionally added to the solvent may be of any one, as long as it is soluble in the solvent. Examples of such surfactants include anionic surfactants such as sodium n-dodecylbenzenesulfonate, cationic surfactants such as n-dodecyltrimethylammonium chloride, and nonionic surfactants such as polyoxyethylene nonylphenol ether (for example, commercially available as Emulgen 910 (trade name) manufactured by Kao Corporation), polyoxyethylene sorbitan monolaurate (for example, commercially available as Tween 20 (trade name)), and polyoxyethylene lauryl ether.

If necessary, a polymerization inhibitor may also be added to the composition containing the compound having the polymerizable group and the interacting group. Examples of polymerization inhibitors that may be used include hydroquinones, such as hydroquinone, di-tert-butylhydroquinone, and 2,5-bis(1,1,3,3-tetramethylbutyl)hydroquinone, phenols such as p-methoxyphenol and phenol, benzoquinones, free radicals such as TEMPO (2,2,6,6-tetramethyl-1-piperidinyloxy free radical) and 4-hydroxyTEMPO, phenothiazines, nitrosamines such as N-nitrosophenylhydroxyamine and an aluminum salt thereof, and catechols.

If necessary, a curing agent and/or a curing accelerator for facilitating the curing of the polymerization initiating layer may also be added to the composition containing the compound having the polymerizable group and the interacting group. When the polymerization initiating layer contains an epoxy compound, the curing agent and/or the curing accelerator may be of polyaddition type, examples of which include aliphatic polyamines, alicyclic polyamines, aromatic polyamines, polyamides, acid anhydrides, phenols, phenol novolac, polymercaptan, and compounds having two or more active hydrogen atoms, or may be of catalytic type, examples of which include aliphatic tertiary amines, aromatic tertiary amines, imidazole compounds, and Lewis acid complexes. Examples of the curing agent and/or the curing accelerator capable of initiating curing by heat, light, moisture, pressure, acid, base, or the like include diethylenetriamine, triethylenetriamine, tetraethylenepentamine, diethylaminopropylamine, polyamide amine, menthenediamine, isophoronediamine, N-aminoethylpiperazine, 3,9-bis(3-aminopropyl)-2,4,8,10-tetraoxyspiro(5,5)undecane adduct, bis(4-amino-3-methylcyclohexyl)methane, bis(4-aminocyclohexyl)methane, m-xylenediamine, diaminodiphenylmethane, m-phenylenediamine, diaminodiphenylsulfone, dicyandiamide, adipic acid dihydrazide, phthalic anhydride, tetrahydrophthalic anhydride, hexahydrophthalic anhydride, methyltetrahydrophthalic anhydride, methylhexahydrophthalic anhydride, methylnadic anhydride, dodecylsuccinic anhydride, chlorendic anhydride, pyromellitic anhydride, benzophenone tetracarboxylic anhydride, ethylene glycol bis(anhydrotrimate), methylcyclohexenetetracarboxylic anhydride, trimellitic anhydride, polyazelaic anhydride, phenol novolac, xylylene novolac, bis A novolac, triphenylmethane novolac, biphenyl novolac, dicyclopentadienephenol novolac, terpene phenol novolac, polymercaptan, polysulfide, 2,4,6-tris(dimethylaminomethyl)phenol, 2,4,6-tris(dimethylaminomethyl)phenol-tri-2-ethylhexanoate, benzyldimethylamine, 2-(dimethylaminomethyl)phenol, 2-methylimidazole, 2-ethyl-4-methylimidazole, 2-undecylimidazole, 2-heptadecylimidazole, 2-phenylimidazole, 1-benzyl-2-methylimidazole, 1-cyanoethyl-2-methylimidazole, 2,4-diamino-6-(2-methylimidazolyl-(1))-ethyl-S-triazine, BF₃ monoethylamine complex, Lewis acid complexes, organic acid hydrazide, diaminomaleonitrile, melamine derivatives, imidazole derivatives, polyamine salts, amine-imide compounds, aromatic diazonium salts, diaryliodonium salts, triarylsulfonium salts, triarylselenium salts, and ketimine compounds.

In view of coatability of the solution or adhesion to the substrate or the plating film, the curing agent and/or the curing accelerator is preferably added in an amount of 0 to about 50% by mass based on the amount of the nonvolatile components left after removal of the solvent. The curing agent and/or the curing accelerator may also be added to the polymerization initiating layer. In such a case, the total amount added to the polymerization initiating layer and the polymer layer should preferably fall within the range.

In addition, a plasticizer, a rubber component (such as CTBN), a flame retardant (such as a phosphorous-based flame retardant), a diluent or a thixotropic agent, a pigment, an anti-foaming agent, a leveling agent, a coupling agent, or the like may also be added. If necessary, any of these additives may be added to the polymerization initiating layer.

Use of a composition prepared by appropriately mixing the compound having the polymerizable group and the interacting group with various additives can make optimal the physical properties of the polymer layer formed, such as the thermal expansion coefficient, glass transition temperature, Young's modulus, Poisson's ratio, rupture stress, yield stress, and thermal decomposition temperature. In particular, the rupture stress, yield stress, and thermal decomposition temperature are preferably as high as possible. The resulting polymer layer may be measured for thermal durability by a temperature cycling test, a heat time-course test, a reflow test, or the like. Concerning the thermal decomposition, for example, when the mass of the polymer layer is reduced by 20% or less after exposure to a 200°C environment for 1 hour, the polymer layer may be evaluated as having satisfactory thermal durability.

In the process of brining the composition containing the compound having the polymerizable group and the interacting group into contact with the substrate, the composition is preferably applied in an amount of 0.1 to 10 g/m², particularly preferably 0.5 to 5 g/m², on a solid basis, in view of sufficient interaction with the plating catalyst or the precursor thereof. When the composition containing the compound having the polymerizable group and the interacting group is applied and dried to form a layer containing the compound having the polymerizable group and the interacting group, the coating may be stored at 30 to 80°C for 30 minutes to 1 hour during the time between the application and the drying so that the solvent residue can be removed.

### Application of Energy

For example, the method of applying energy to the surface of the substrate may use heating or application of radiations such as exposure to light. For example, photoirradiation with an UV lamp, visible rays, or the like, or heating with a hot plate or the like may be performed. Examples of light sources include mercury lamps, metal halide lamps, xenon lamps, chemical lamps, and carbon arc lamps. Examples of radiations include electron beams, X rays, ion beams, and far infrared rays. In addition, g-line, i-line, Deep-UV light, or high-density energy beams (laser beams) may also be used. Examples of specific modes generally used preferably include direct image-like recording with a thermal recording head or the like, scanning exposure with an infrared laser, high-illumination flash exposure with a xenon discharge lamp or the like, and infrared lamp exposure. The time required for the application of energy is generally from 10 seconds to 5 hours, depending on the amount of the graft polymer to be produced and the type of the light source.

When the application of energy is performed by exposure to light, the exposure is preferably performed at a power of 10 mJ/cm² to 5000 mJ/cm², more preferably 50 mJ/cm² to 3000 mJ/cm², in order to facilitate the graft polymerization and to prevent the decomposition of the produced graft polymer. When a polymer with an average molecular weight of 20,000 or more and a polymerization degree of 200 or more is used as the compound having the polymerizable group and the interacting group, the graft polymerization can readily proceed upon low-energy exposure, and, therefore, decomposition of the produced graft polymer can be further reduced.

The step (a1) described above allows the formation of a polymer layer (graft polymer layer) including an interacting group-containing graft polymer on the substrate.

If the resulting polymer layer is decomposed by 50% or less when it is added to an alkaline solution with a pH of 12 and stirred for 1 hour, the polymer layer may be washed with a highly alkaline solution.

### Step (a2)

In the step (a2), a multidentate plating catalyst or a precursor thereof is applied to the polymer layer formed by the step (a1). In this step, the applied plating catalyst or the applied precursor thereof is attached (adsorbed) to the interacting group of the graft polymer that forms the polymer layer, according to the function of the interacting layer. In this step, the plating catalyst or the precursor thereof may be a material capable of functioning as a catalyst or an electrode for plating in the plating step (a4) described later. Therefore, the plating catalyst or the precursor thereof should be determined depending on the type of the plating in the plating step (a4). The plating catalyst or the precursor thereof used in this step is preferably an electroless plating catalyst or a precursor thereof.

### Electroless Plating Catalyst

The plating catalyst used in an embodiment of the invention may be of any type, as long as it is multidentate. Specifically, the plating catalyst may be a multidentate metal having catalytic activity for an autocatalytic reducing reaction, such as Pd, Ag, Cu, Ni, Al, Fe, or Co. Pd is particularly preferred, because of its high catalytic activity and the variety of multidentate functional groups.

### Precursor of Electroless Plating Catalyst

The precursor of the electroless plating catalyst for use in this step may be of any type, as long as it can be converted into an electroless plating catalyst by a chemical reaction. In general, metal ions derived from the metal listed as the electroless plating catalyst may be used. A metal ion used as a precursor of the electroless plating catalyst is converted into a zero-valent metal, which is an electroless plating catalyst, by a reducing reaction. The metal ion used as a precursor of an electroless plating catalyst may be applied to the polymer layer and then converted into a zero-valent metal, which serves as the electroless plating catalyst, by an independent reducing reaction, before immersion into an electroless plating bath. Alternatively, a precursor of an electroless plating catalyst may be immersed in an electroless plating bath and converted into a metal (an electroless plating catalyst) by means of a reducing agent in the electroless plating bath.

Practically, the metal ion used as a precursor of an electroless plating catalyst may be applied in the form of a metal salt to the polymer layer. The metal salt to be used may be of any type, as long as it is soluble in a solvent and can dissociate into a metal ion and a base (anion), and examples of such a metal salt include M(NO₃)ₙ, MClₙ, M_{2/n}(SO₄), and M_{3/n}(PO₄), wherein M represents a n-valent metal atom. Metal ions produced when the above metal salt dissociates are preferably used. Examples of metal ions include Ag ions, Cu ions, Al ions, Ni ions, Co ions, Fe ions, and Pd ions. From view points of the variety of multidentate functional groups and the level of catalytic activity, Pd ions are preferred in terms of catalytic activity.

The method for applying, to the polymer layer, a metal as an electroless plating catalyst or a metal salt as a precursor of an electroless plating catalyst may include preparing a dispersion of the metal in an appropriate dispersing medium or a solution of the metal salt in an appropriate solvent, which contains dissociated metal ions, and applying the dispersion or the solution to the polymer layer, or immersing the polymer layer-carrying substrate in the dispersion or the solution. When the electroless plating catalyst or the precursor thereof is in contact with the polymer layer, the electroless plating catalyst or the precursor thereof can be adsorbed to the interacting group in the polymer layer based on the interaction caused by an intermolecular force such as Van der Waals force or based on the coordinate bond formed by lone-pair electrons. In order to allow the adsorption to proceed sufficiently, the concentration of the metal in the dispersion to be in contact or the concentration of the metal ion in the solution to be in contact is preferably from 0.001 to 50% by mass, more preferably from 0.005 to 30% by mass. The contact time period is preferably from about 30 seconds to about 24 hours, more preferably from about 1 minute to about 1 hour.

### Other Catalysts

In an embodiment of the invention, a zero-valent metal may be used as a catalyst, when electroplating is directly performed on the polymer layer in the step (a4) described later without electroless plating. Examples of such a zero-valent metal include Pd, Ag, Cu, Ni, Al, Fe, and Co. Pd, Ag, and Cu are particularly preferred, because of their high catalytic activity and adsorption (adhesion) properties to the interacting group. This catalyst can function to form an electrode for electroplating in the step (a4). Such other catalysts may be applied to the polymer layer by the same method as in the application of the electroless plating catalyst or the precursor thereof.

The step (a2) described above allows the interacting group in the polymer layer to interact with the placing catalyst or the precursor thereof.

### Step (a3)

In the step (a3), a metal different from the multidentate plating catalyst or the precursor thereof (herein after also referred to as a "different metal") is added to the polymer layer. This step may be performed on the polymer layer having the plating catalyst or the precursor thereof applied in the step (a2) or may be performed simultaneously with the formation of the polymer layer in the step (a1). In the latter case, the different type metal may be previously added to the composition containing the compound having the polymerizable group and the interacting group so that a different type metal-containing polymer layer can be formed using the composition. The different type metal may also be contained in the form of a metal ion in the polymer layer.

The different type metal used in this step may be of any type, as long as it differs from the multidentate plating catalyst or the precursor thereof used in the step (a2). The different type metal is preferably capable of interacting with (adsorbing to) the interacting group in the polymer layer and functioning as an electroless plating catalyst or an electrode. Therefore, the type of the different type metal to be used in the step (a3) is preferably determined depending on the type of the plating in the step (a4) described later. Specifically, the different type metal used in this step is preferably silver (Ag), copper (Cu), nickel (Ni), cobalt (Co), tin (Sn), chromium (Cr), or zinc (Zn). In particular, silver, copper, or nickel is more preferred, because of their high suitability for electroless plating.

The method for applying the different type metal to the polymer layer provided with the multidentate plating catalyst or the precursor thereof in step (a2) may include preparing a dispersion of the different type metal in an appropriate dispersing medium or an appropriate solvent solution containing dissociated metal ions, and applying the dispersion or the solution to the polymer layer, or immersing the polymer layer-carrying substrate in the dispersion or the solution. The applied different type metal is adsorbed to the interacting group in the polymer layer based on the interaction caused by an intermolecular force such as Van der Waals force or based on the coordinate bond formed by lone-pair electrons (unshared electron pair). In order to allow the adsorption to proceed sufficiently, the concentration of the metal in the dispersion to be in contact or the concentration of the metal ion in the solution to be in contact is preferably from 0.001 to 50% by mass, more preferably from 0.005 to 30% by mass. The contact time period is preferably from about 30 seconds to about 24 hours, more preferably from about 1 minute to about 1 hour.

When this step uses a method of adding the different type metal to the composition containing the compound having the polymerizable group or the interacting group, the different type metal is preferably added in an amount of 0.001 to 100% by mass, more preferably 0.005 to 50% by mass, based on the amount of the solids of the composition.

After the step (a3) described above, the polymer layer contains the different type metal in addition to the plating catalyst or the precursor thereof.

### Step (a4)

In the step (a4), plating is performed on the polymer layer provided with the electroless plating catalyst or the precursor thereof, so that a plating film is formed. The resulting plating film has a high level of electrical conductivity and adhesion. The type of the plating performed in this step may be electroless plating, electroplating, or the like, and it may be selected depending on the function of the different type metal and the type of the plating catalyst or the precursor thereof that interacts with the polymer layer in the steps (a2) and (a3). Specifically, in this step, electroplating or electroless plating may be performed on the polymer layer provided with the plating catalyst or the precursor thereof. In a particularly preferred embodiment of the invention, electroless plating is performed in view of the ability to produce a hybrid structure in the polymer layer and the improvement in adhesion. In a more preferred embodiment, electroplating is further performed to form a plating layer with the desired thickness, after the electroless plating. A description is given below of the plating preferably performed in this step.

### Electroless Plating

Electroless plating means a process for depositing metal by a chemical reaction using a solution containing ions of the metal to be deposited by the plating. In this step, electroless plating is typically performed by immersing the substrate in an electroless plating bath, after the substrate provided with the electroless plating catalyst and the different type metal is washed with water so that excess part of the electroless plating catalyst (metal) can be removed. In this process, generally known electroless plating baths may be used. The substrate provided with the electroless plating catalyst precursor and ions of the different type metal may also be used, in which the electroless plating catalyst precursor and the ions of the different type metal are adsorbed to or infiltrated into the polymer layer. In this case, the substrate may be immersed in an electroless plating bath, after it is washed with water so that excess part of the precursor (a metal salt or the like) can be removed. In this case, the electroless plating catalyst precursor and the ions of the different type metal are reduced in the electroless plating bath, and subsequently, the electroless plating is performed. In this case, generally known electroless plating baths may also be used as described above. As an alternative to the case of using the electroless plating liquid as described above, a catalyst activating liquid (a reducing liquid) may be prepared, and the reduction of the electroless plating catalyst precursor and the ions of the different type metal may be performed in a separate step before the electroless plating. The catalyst activating liquid is a solution of a reducing agent capable of reducing the electroless plating catalyst precursor (generally metal ion) and the different type metal ion to zero-valent metal, which is preferably from 0.1 % to 50%, more preferably from 1% to 30%. The reducing agent may be a boron-based reducing agent such as sodium borohydride or dimethylamine borane, or formaldehyde, hypophosphorous acid, or the like.

The components of the electroless plating bath generally include (1) metal ions for plating, (2) a reducing agent, and (3) an additive to increase the stability of the metal ions (stabilizer). Besides these materials, the plating bath may also contain any known additive such as a stabilizer for the plating bath. The metal for use in the electroless plating bath was known to be copper, tin, lead, nickel, gold, palladium, or rhodium, and in particular, copper or gold is preferred in view of electrical conductivity. There is also a most suitable reducing agent or additive for the metal. For example, an electroless copper plating bath should contain CuSO₄ as a copper salt, HCOH as a reducing agent, and an additive such as an copper ion stabilizing agent (such as EDTA or a chelating agent such as Rochelle salt) or trialkanolamine. A plating bath for use in electroless CoNiP plating should contain cobalt sulfate and nickel sulfate as the metal salts, sodium hypophosphite as a reducing agent, and sodium malonate, sodium malate, and sodium succinate as complexing agents. An electroless palladium plating bath should contain (Pd(NH₃)₄)Cl₂ for metal ions, NH₃ and H₂NNH₂ as reducing agents, and EDTA as a stabilizer. Besides the above components, these plating baths may also contain other components.

The thickness of the plating film formed by the electroless plating as described above may be controlled by the concentration of the metal ion in the plating bath, the time of the immersion in the plating bath, the temperature of the plating bath, or the like. In view of electrical conductivity, the thickness of the plating film is preferably 0.1 µm or more, more preferably 0.3 µm or more. The time of the immersion in the plating bath is preferably from about 1 minute to about 6 hours, more preferably from about 1 minute to about 3 hours.

Cross-sectional observation by SEM has revealed that the plating film produced by the electroless plating as described above is composed of the metal deposited on the polymer layer and fine particles of the electroless plating catalyst, the different type metal, and the deposited metal, which are densely dispersed into the polymer layer. The interface between the substrate and the plating film is in a state of a hybrid of the polymer and the fine particles. Therefore, good adhesion is provided between them, even when the interface between the substrate (an organic component) and the inorganic material (the catalytic metal or the deposited metal) is smooth (for example, when the height difference is 500 nm or less).

### Electroplating

When the plating catalyst or the precursor thereof applied in the step (a2) and the different type metal added to the polymer layer in the step (a3) each function as an electrode material, electroplating may be performed on the catalyst- or precursor-carrying polymer layer. After the electroless plating described above, electroplating may also be performed using the resulting plating film as an electrode. In this process, another metal film having a desired thickness can be easily formed on the basis of the electroless plating film with good adhesion to the substrate. The electroplating performed after the electroless plating can form a metal film with the desired thickness according to the purpose and therefore is preferred when the metal film of the invention is made suitable for various applications.

In an embodiment of the invention, the electroplating may be performed using known conventional methods. The metal used for the electroplating in this step may be copper, chromium, lead, nickel, gold, silver, tin, zinc, or the like. In view of electrical conductivity, the metal is preferably copper, gold, or silver, more preferably copper.

The thickness of the metal film produced by the electroplating depends on use and may be controlled by adjusting the concentration of the metal in the plating bath, the current density, or the like. The thickness of the metal film for use in general electrical wirings is preferably 0.5 µm or more, more preferably 3 µm or more, in view of electrical conductivity.

In an embodiment of the invention, the metal or metal salt derived from the plating catalyst or the plating catalyst precursor and/or the electroless plating can form a fractal-like fine structure of the deposited metal in the polymer layer so that the adhesion between the metal film and the polymer layer can be further improved. Concerning the amount of the metal in the polymer layer, the metal should make up 5 to 50% by area of the region from the uppermost surface of the polymer layer to a depth of 0.5 µm, when the cross-section of the substrate is photographed through a metallurgical microscope. When the interface between the polymer layer and the metal has an arithmetic mean roughness Ra of 0.05 µm to 0.5 µm (JIS B 0633 (2001)), higher adhesive strength can be achieved.

### Method (1) for Preparing Metal Pattern Material

In a first aspect, the method of the invention for preparing a metal pattern material includes: (b1) forming a polymer layer on a substrate, wherein the polymer layer includes a polymer that has a non-dissociating multidentate functional group capable of interacting with a plating catalyst or a precursor thereof and is directly and chemically bonded to the substrate; (b2) applying a multidentate plating catalyst or a precursor thereof to the polymer layer; (b3) optionally adding a metal to the polymer layer, wherein the metal is different from the multidentate plating catalyst or the precursor thereof; (b4) performing plating on the multidentate plating catalyst or the precursor thereof; and (b5) etching the resulting plating film in a pattern. A description is given below of the steps (b1) to (b5) of the method (1) for preparing a metal pattern material.

### Step (b1)

In the step (b1), a polymer layer is formed on a substrate, wherein the polymer layer includes a polymer that has a non-dissociating multidentate functional group capable of interacting with a plating catalyst or a precursor thereof (interacting group) and is directly and chemically bonded to the substrate. The step (b1) of the method (1) for preparing a metal pattern material is the same as the step (a1) of the method for preparing a metal film-carrying substrate, and preferred aspects are also the same.

### Step (b2)

In the step (b2), a multidentate plating catalyst or a precursor thereof is applied to the polymer layer formed in the step (b1). The step (b2) of the method (1) for preparing a metal pattern material is the same as the step (a2) of the method for preparing a metal film-carrying substrate, and preferred aspects are also the same.

### Step (b3)

In the step (b3), a metal different from the multidentate plating catalyst or the precursor thereof (different type metal) is added to the polymer layer. The step (b3) of the method (1) for preparing a metal pattern material is the same as the step (a3) of the method for preparing a metal film-carrying substrate, and preferred aspects are also the same.

### Step (b4)

In the step (b4), plating is performed on the multidentate catalyst or the precursor thereof attached to the polymer layer formed in the step (b2). The step (b4) of the method (1) for preparing a metal pattern material is the same as the step (a4) of the method for preparing a metal film-carrying substrate, and preferred aspects are also the same.

### Step (b5)

In the step (b5), the plating film formed in the step (b4) is etched in a pattern. Specifically, in this step, an unnecessary portion of the plating film formed on the entire surface of the substrate may be removed by etching so that the desired metal pattern can be formed. The metal pattern may be formed by any method such as a generally known subtractive method or semi-additive method.

The subtractive method may include providing a dry film resist layer on the resulting plating film, performing pattern exposure, forming a resist pattern corresponding to the metal pattern by development, and partially removing the plating film through the patterned dry film resist mask with an etching solution to form a metal pattern. Any dry film resist material such as negative type, positive type, liquid type, or film type may be used. Any etching method that has been used for the production of printed circuit boards may be used, such as wet etching and dry etching, and the method may be selected as desired. Wet etching is preferred, because its system or the like is relatively simple in terms of operation. For example, an aqueous solution of cupric chloride, ferric chloride, or the like may be used as the etching solution.

The semi-additive method may include providing a dry film resist layer on the resulting plating film, performing pattern exposure, forming a resist pattern corresponding to the non-metal pattern portion by development, performing electroplating through the dry film resist pattern mask, removing the dry film resist pattern, and then performing quick etching to remove the plating film in a patter so that a metal pattern is formed. The dry film resist material, the etching solution, and so on may be the same as those used in the subtractive method. The electroplating technique described above may also be used.

A metal pattern material having the desired metal pattern is prepared through the steps described above.

### Method (2) for Preparing Metal Pattern Material

In a second aspect, the method of the invention for preparing a metal pattern material includes: (c1) forming a polymer layer in a pattern on a substrate, wherein the polymer layer includes a polymer that has a non-dissociating multidentate functional group capable of interacting with a plating catalyst or a precursor thereof and is directly and chemically bonded to the substrate; (c2) applying a multidentate plating catalyst or a precursor thereof to the polymer layer; (c3) optionally adding a metal to the polymer layer, wherein the metal is different from the multidentate plating catalyst or the precursor thereof; and (c4) performing plating on the multidentate plating catalyst or the precursor thereof. Therefore, the method (2) for preparing a metal pattern material includes forming a polymer layer in a pattern on a substrate and forming a metal pattern according to the polymer layer pattern, while the method (1) for preparing a metal pattern material includes forming a polymer layer over the surface of a substrate and partially removing the plating film formed on the polymer layer to form the desired metal pattern.

A description is given below of the steps (c1) to (c4) of the method (2) for preparing a metal pattern material.

### Step (c1)

In the step (c1), a polymer layer is formed in a pattern on a substrate, wherein the polymer layer includes a polymer that has a non-dissociating multidentate functional group capable of interacting with a plating catalyst or a precursor thereof and is directly and chemically bonded to the substrate. The step (c1) of the method (2) for preparing a metal pattern material may be performed according to the technique described above for the step (a1) of the method for preparing a metal film-carrying substrate. In the method for preparing a metal film-carrying substrate, the polymer layer is formed over the surface of the substrate, but in this embodiment, the polymer layer is formed in a pattern. More specifically, in the step (c1), energy may be applied in a pattern so that the polymer layer can be formed in a pattern. On the other hand, in the step (a1) of the method for preparing a metal film-carrying substrate, energy is applied to the entire surface of the substrate when the surface graft polymerization method is used to form the polymer layer.

The substrate (the base material, the intermediate layer that may be formed on the base material, and the polymerization initiating layer), the respective elements for use in forming the polymer layer, and so on described in detail for the step (a1) of the method for preparing a metal film-carrying substrate may be used in a similar manner in the step (c1).

### Application of Energy

In the step (c1), any method capable of applying energy in a pattern such that active sits can be produced on the substrate surface may be used. For example, means for applying energy in a pattern may be an infrared laser, an ultraviolet lamp, photoirradiation with visible light or the like, electron beam irradiation with γ rays or the like, thermal recording with a thermal head, or the like. In view of cost and system simplicity, actinic ray irradiation method is preferred. Examples of light sources include mercury lamps, metal halide lamps, xenon lamps, chemical lamps, and carbon arc lamps. Examples of radiations include electron beams, X rays, ion beams, and far infrared rays. In addition, g-line, i-line, Deep-UV light, or high-density energy beams (laser beams) may also be used. Examples of specific embodiemnts generally used preferably include direct image-like recording with a thermal recording head or the like, scanning exposure with an infrared laser, high-illumination flash exposure with a xenon discharge lamp or the like, and infrared lamp exposure. When actinic rays are applied in a pattern, any of scanning exposure based on digital data and pattern exposure through a lith. film may be used.

The application of energy in a pattern induces production of active sites on the substrate surface and polymerization of the active sites and the compound having the polymerizable group and the interacting group so that a graft polymer is produced only in the region to which the energy is applied.

### Steps (c2), (c3), and (c4)

The steps (c2), (c3), and (c4) of the method (2) for preparing a metal pattern material are the same as the steps (a2), (a3), and (a4) of the method for preparing a metal film-carrying substrate, respectively, and preferred embodiemnts are also the same.

A metal pattern material having a metal pattern according to the polymer layer pattern is prepared through the steps described above.

### Metal Film-Carrying Substrate and Metal Pattern Material

The metal film-carrying substrate and the metal pattern material of the invention are each prepared by the method of the invention. As described above, the polymer layer that forms the resulting metal film-carrying substrate or the metal pattern material has a non-dissociating group that is less hydrophilic than dissociating groups, although it interacts with the plating catalyst or the precursor thereof. Therefore, the polymer layer itself is less hydrophilic and less dependent on temperature or humidity, so that the metal film (plating) formed on the polymer layer or the substrate can be prevented from being deformed. Even when the polymer layer is left in the metal pattern-free region of the metal pattern material (prepared by the method (1) of the invention), a high level of insulating reliability is provided, because the metal pattern-free region is less hydrophilic. On the other hand, the polymer layer is not present in the metal pattern-free region of the metal pattern material prepared by the method (2) of the invention, so that a high level of insulation reliability is provided.

The metal film-carrying substrate or the metal pattern material of the invention preferably includes a substrate whose surface roughness is 500 nm or less (more preferably 100 nm or less) and a metal film (plating film) provided over the surface of the substrate or on a local part of the substrate. The adhesion between the substrate and the metal film (patterned metal) is preferably 0.2 kN/m or more. Therefore, it is **characterized in that** a high level of adhesion is provided between the substrate and the metal film (patterned metal), while the surface of the substrate is smooth.

The surface roughness of the substrate may be a value measured by observation of a cross-section obtained by cutting the substrate perpendicularly to the substrate surface. More specifically, the Rz measured according to JIS B 0601, namely the difference between the average of Z data of the top five peaks and the average of the top five bottoms with respect to the designated plane, is preferably 500 nm or less. The value of the adhesion between the substrate and the metal film may be obtained by a process that includes bonding a copper sheet (0.1 mm in thickness) to the surface of the metal film with an epoxy adhesive (Araldite (trade name), manufactured by Ciba-Geigy), drying them at 140°C for 4 hours, and then performing the 90° peel test according to JIS C 6481, or by a process that includes directly peeling the end of the metal film itself and performing the 90° peel test according to JIS C 6481.

The metal film-carrying substrate prepared by the method of the invention may be used for various applications such as electromagnetic wave shielding films or semiconductor chips, various electrical wiring boards, FPC, COF, TAB, antennas, multilayer circuit boards, and mother boards, with the metal film (plating film) patterned by etching. The metal pattern materials prepared by the methods (1) and (2) may also be used for the various applications described above.

### EXAMPLES

The present invention is more specifically described with the examples below which are not intended to limit the scope of the invention. Unless otherwise stated, "%" and "parts" are all by mass.

### Example 1

### Preparation of Substrate

An epoxy-based insulating film GX-13 (45 µm in thicknss) manufactured by Ajinomoto Fine-Techno Co., Inc. was heated and press-bonded to a glass epoxy support under the conditions of 100°C to 110°C and a pressure of 0.2 MPa with a vacuum laminator so that a base material A having an electrical insulating layer was obtained. A polymerization initiator-containing insulating composition including the components described below was then applied with a thickness of 3 µm to the base material A by spin coating. The coating was allowed to stand at 30°C for 1 hour so that the solvent was removed. The coating was then dried at 170°C for 30 minutes to form a polymerization initiating layer (an insulating polymerization-initiating layer).

### Polymerization Initiator-Containing Insulating Composition

Twenty parts by mass of a bisphenol A epoxy resin (185 in epoxy equivalent, Epicoat 828 (trade name), manufactured by Japan Epoxy Resins Co., Ltd.), 45 parts by mass of an epoxy cresol novolac resin (215 in epoxy equivalent, Epiclon N-673 (trade name), manufactured by DIC Corporation), and 30 parts by mass of a phenol novolac resin (105 in phenolic hydroxyl equivalent, Phenolite (trade name), manufactured by DIC Corporation) were dissolved in 20 parts of ethyl diglycol acetate and 20 parts of solvent naphtha under heating and stirring and cooled to room temperature. To the mixture were then added 30 parts by mass of a cyclohexanone varnish of a phenoxy resin derived from Epicoat 828 and bisphenol S (YL6747H30 (trade name), with a non-volatile content of 30% by mass and a weight average molecular weight of 47,000, manufactured by Japan Epoxy Resins Co., Ltd.), 0.8 parts by mass of 2-phenyl-4,5-bis(hydroxymethyl)imidazole, 2 parts by mass of pulverized silica, and 0.5 parts by mass of a silicone anti-foaming agent. Ten parts of the polymerization initiating polymer P synthesized by the method described below was further added to the resulting mixture so that a polymerization initiator-containing insulating composition was obtained.

### Synthesis of Polymerization Initiating Polymer P

To a 300 ml three-neck flask was added dropwise 30 g of propylene glycol monomethyl ether (MFG) and heated to 75°C. Thereto was added a solution of 8.1 g of [2-(acryloyloxy)ethyl](4-benzoylbenzyl)dimethyl ammonium bromide, 9.9 g of 2-hydroxyethyl methacrylate, 13.5 g of isopropyl methacrylate, 0.43 g of dimethyl-2,2'-azobis(2-methyl propionate), and 30 g of MFG over 2.5 hours. The reaction temperature was then raised to 80°C, and the reaction was further performed for 2 hours so that a polymerization initiating group-containing polymer P was obtained.

After the polymerization initiating layer was formed, it was cured at 180°C for 30 minutes, so that a substrate A1 was obtained. The substrate A1 had a surface roughness (Rz) of 0.1 µm.

### Formation of Polymer Layer

### Synthesis of Polymer 1 Having Polymerizable Group and Interacting Group

A polymer 1 having a polymerizable group and an interacting group was synthesized as described below. To a 1,000 ml three-neck flask was added 20 g of N,N-dimethylacetamide and heated to 75°C under a nitrogen gas stream. Thereto was added dropwise a solution of 8.6 g of 2-hydroxyethyl acrylate, 31.1 g of 4-vinylpyridine (a monomer having an interacting group), and 0.85 g of V-601 (trade name, manufactured by Wako Pure Chemical Industries, Ltd.) in 20 g of N,N-dimethylacetamide over 2.5 hours. After the addition was completed, the mixture was heated to 80°C and further stirred for 3 hours. The reaction solution was then cooled to room temperature. To the reaction solution were added 0.37 g of di-tert-pentyl hydroquinone, 0.47 g of dibutyltin dilaurate, 23.3 g of Karenz AOI (trade name, manufactured by Showa Denko K.K.), and 25 g of N,N-dimethylacetamide and allowed to react at 55°C for 4 hours. Thereafter, 20.0 g of methanol was added to the reaction liquid, and the reaction was further performed for 2 hours. After the reaction was completed, reprecipitation was performed, and the solid was separated by filtration, washed with water, and dried so that 15 g of a polymer 1 (of the structure shown below) having a polymerizable group and an interacting group was obtained. Karenz AOI has an isocyanate group, which corresponds to a monomer having a polymerizable group.

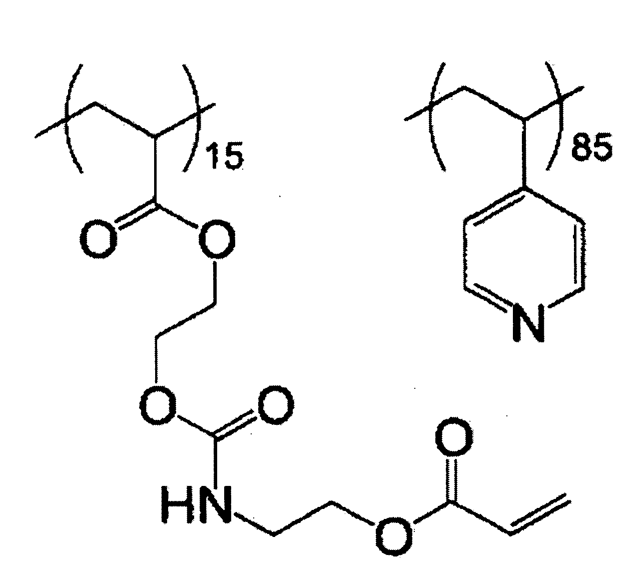

### Production of Graft Polymer

A coating solution was prepared by mixing and stirring 9.6 parts by mass of the polymer 1 having a polymerizable group and an interacting group, 76.0 parts by mass of isopropanol, 33.9 parts by mass of methanol, and 4.8 parts by mass of N,N-dimethylacetamide. The prepared coating solution was then applied with a thickness of 1.0 µm to the polymerization initiating layer of the substrate A by spin coating with a spin coater. The coating was dried at 80°C for 30 minutes and then irradiated at a power of 1.5 mW/cm² (which was measured with an accumulated UV meter UIT 150 (with a light-receiving sensor UVD-S254) manufactured by Ushio Inc.) for 660 seconds using a UV exposure system manufactured by San-Ei Electric Co., Ltd. (model No. UVF-502S, lamp: UXM-501MD), so that a graft polymer was produced on the entire surface of the polymerization initiating layer of the substrate A1.

The substrate A1 provided with the graft polymer was then immersed in methanol for 5 minutes under stirring and then washed with distilled water, so that a polymer layer-carrying substrate A2 was obtained.

### Application of Plating Catalyst

The polymer layer-carrying substrate A2 was immersed in an aqueous 0.2% by mass palladium chloride solution for 10 minutes and then immersed in distilled water for washing. A catalyst activating liquid (a reducing liquid) was prepared by adding 18 mL of a treatment liquid MRD 2A and 60 mL of a treatment liquid MRD 2C (each manufactured by Uyemura & Co., Ltd.) to 1 L of water. The polymer layer-carrying substrate A2 was then immersed in the catalyst activating liquid for 5 minutes and then immersed in distilled water for washing.

### Application of Different Type Metal

The polymer layer-carrying substrate A2 was then immersed in an aqueous 1% by mass silver nitrate solution for 10 minutes and then immersed in distilled water for washing.

### Electroless Plating

The polymer layer-carrying substrate A2 to which the plating catalyst was attached as described above was electroless-plated at 60°C for 5 minutes using an electroless plating bath having the composition shown below. The resulting electroless-deposited copper film had a thickness of 0.3 µm.

### Composition of Electroless Plating Bath

Distilled water 1709 g
Copper sulfate 18.1 g
Ethylenediaminetetraacetic acid disodium salt 54.0 g
Polyoxyethylene glycol (1000 in molecular weight) 0.18 g
2,2'-bipyridyl 1.8 mg
Aqueous 10% ethylenediamine solution 7.1 g
Aqueous 37% formaldehyde solution 9.8 g
The pH of the plating bath composition was adjusted to 12.5 (60°C) with sodium hydroxide and sulfuric acid.

### Electroplating

Electroplating was then performed under the condition of 3 A/dm² for 30 minutes using a copper electroplating bath having the composition shown below, while the electroless-deposited copper film was used as an electric supply layer. The resulting electro-deposited copper film had a thickness of 18 µm. As a result, a metal film-carrying substrate A3 was obtained.

### Composition of Electroplating Bath

Copper sulfate 3 8 g
Sulfuric acid 95 g
Hydrochloric acid 1 mL
Copper Gleam PCM (trade name, manufactured by Meltex Inc.) 3 mL
Water 500 g

### Evaluation of Adhesion

The plating film of the resulting metal film-carrying substrate A3 was measured for 90° peel strength at a tensile strength of 10 mm/minute with respect to a width of 5 mm using a tensile tester (RTM-100 (trade name), manufactured by A & D Company, Limited). The measured peel strength was 0.65 kN/mm.

### Insulation Reliability Test

An etching resist was formed on the surface of the plating film of the metal film-carrying substrate A3 in such a manner that the region to form a metal pattern (wiring pattern) would be covered with the resist. The plating film portion not covered with the resist was removed using a FeCl₃/HCl etching solution. The etching resist was then removed using an alkali delamination solution composed of 3% NaOH, so that a comb-shaped wiring with a line and space of 100 µm/100 µm was formed for measurement of the reliability of insulation between lines. The comb-shaped wiring was stored at 125°C and 85% relative humidity (unsaturated) at an applied voltage of 10 V and a pressure of 2 atm for 200 hours in a HAST testing machine (trade name: AMI-150S-25) manufactured by ESPEC CORP. As a result, insufficient insulation was not observed between the lines. This shows that the polymer layer that forms the comb-shaped wiring is less water-absorptive and less dependent on temperature and humidity, because insufficient insulation was not observed after the storing at high temperature and high humidity. Therefore, it has been found that the polymer layer that forms the metal film-carrying substrate A3 is also less water-absorptive and less dependent on temperature and humidity before the comb-shaped wiring is formed.

### Example 2

A metal film-carrying substrate was obtained using the process of Example 1, except that the aqueous different type metal solution used in Example 1 was replaced by an aqueous 1 wt% nickel sulfate hexahydrate solution. The 90° peel strength of the resulting metal film-carrying substrate was measured by the same method as in Example 1. The measured peel strength was 0.64 kN/m. The insulation reliability test was performed in the same manner as in Example 1, and as a result, insufficient insulation was not observed between the lines.

### Example 3

A metal film-carrying substrate was obtained using the process of Example 1, except that 33.9 parts by mass of methanol that was used to form the coating solution containing the polymer 1 having a polymerizable group and an interacting group was replaced by 33.9 parts by mass of an ethanol solution of 1% silver trifluoroacetate. The 90° peel strength of the resulting metal film-carrying substrate was measured by the same method as in Example 1. The measured peel strength was 0.68 kN/m. The insulation reliability test was performed in the same manner as in Example 1, and as a result, insufficient insulation was not observed between the lines.

### Example 4

A metal film-carrying substrate was obtained using the process of Example 1, except that the different type metal application process was omitted. The 90° peel strength of the resulting metal film-carrying substrate was measured by the same method as in Example 1. The measured peel strength was 0.60 kN/m. The insulation reliability test was performed in the same manner as in Example 1, and as a result, insufficient insulation was not observed between the lines.

The results show that according to the invention, metal films (metal patterns) formed on a smooth substrate have good adhesion to the substrate, and the metal pattern-free regions have a high level of insulation reliability. Therefore, printed circuit boards with a high level of electric reliability are obtained using the metal film-carrying substrate (the metal pattern material) produced according to the invention.

## Claims

1. A method for preparing a metal film-carrying substrate, comprising:
(a1) forming a polymer layer on a substrate, the polymer layer comprising a polymer that has a non-dissociating multidentate functional group capable of interacting with a plating catalyst or a precursor thereof and is directly and chemically bonded to the substrate;
(a2) applying a multidentate plating catalyst or a precursor thereof to the polymer layer; and
(a4) performing plating on the multidentate plating catalyst or precursor thereof; and
(a3) optionally adding a metal to the polymer layer after the step (a2), the metal being different from the multidentate plating catalyst or precursor thereof.

2. The method for preparing a metal-carrying substrate of claim 1, wherein the non-dissociating multidentate functional group capable of interacting with the plating catalyst or precursor thereof is a nitrogen-containing functional group, an oxygen-containing functional group, or a sulfur-containing functional group.

3. The method for preparing a metal-carrying substrate of claim 1 or 2, wherein the non-dissociating multidentate functional group capable of interacting with the plating catalyst or precursor thereof is a nitrogen-containing functional group.

4. The method for preparing a metal-carrying substrate of any one of claims 1 to 3, wherein the multidentate plating catalyst or precursor thereof is palladium or a palladium ion.

5. The method for preparing a metal-carrying substrate of any one of claims 1 to 4, wherein the metal being different from the multidentate plating catalyst or precursor thereof is silver, copper, nickel, cobalt, tin, chromium, or zinc.

6. A metal film-carrying substrate prepared by the method of any one of claims 1 to 5.

7. A method for preparing a metal pattern material, comprising:
(b1) forming a polymer layer on a substrate, the polymer layer comprising a polymer that has a non-dissociating multidentate functional group capable of interacting with a plating catalyst or a precursor thereof and is directly and chemically bonded to the substrate;
(b2) applying a multidentate plating catalyst or a precursor thereof to the polymer layer;
(b4) performing plating on the multidentate plating catalyst or precursor thereof; and
(b5) etching the resulting plating film in a pattern; and
(b3) optionally adding a metal to the polymer layer after the step (b2), the metal being different from the multidentate plating catalyst or precursor thereof.

8. A method for preparing a metal pattern material, comprising:
(c1) forming a polymer layer in a pattern on a substrate, the polymer layer comprising a polymer that has a non-dissociating multidentate functional group capable of interacting with a plating catalyst or a precursor thereof and is directly and chemically bonded to the substrate;
(c2) applying a multidentate plating catalyst or a precursor thereof to the polymer layer; and
(c4) performing plating on the multidentate plating catalyst or precursor thereof; and
(c3) optionally adding a metal to the polymer layer after the step (c2), the metal being different from the multidentate plating catalyst or precursor thereof.

9. The method for preparing a metal pattern material of claim 7 or 8, wherein the non-dissociating multidentate functional group capable of interacting with the plating catalyst or precursor thereof is a nitrogen-containing functional group, an oxygen-containing functional group, or a sulfur-containing functional group.

10. The method for preparing a metal pattern material of any one of claims 7 to 9, wherein the non-dissociating multidentate functional group capable of interacting with the plating catalyst or precursor thereof is a nitrogen-containing functional group.

11. The method for preparing a metal pattern material of any one of claims 7 to 10, wherein the multidentate plating catalyst or precursor thereof is palladium or a palladium ion.

12. The method for preparing a metal pattern material of any one of claims 7 to 11, wherein the metal being different from the multidentate plating catalyst or precursor thereof is silver, copper, nickel, cobalt, tin, chromium, or zinc.

13. A metal pattern material prepared by the method of any one of claims 7 to 12.
